# DEMANDE DE BREVET EUROPEEN

(11) **EP 4 270 601 A2**
(43) Date de publication de la demande: **01.11.2023**
(21) Numéro de dépôt: 23170445.3
(22) Date de dépôt: 27.04.2023
(51) Int. Cl.: H01M 10/613, H01M 10/653, H01M 10/6569, H01M 10/667, H01M 50/204, H01M 50/224, H01M 50/229, H01M 50/231

(54) **SYSTEME DE REFROIDISSEMENT COMBINE POUR ELECTRONIQUE ET DISPOSITIF DE STOCKAGE D ENERGIE**

(30) Priorité: 29.04.2022 FR 2204112
(71) Demandeur: Commissariat à l'Energie Atomique et aux Energies Alternatives, 75015 Paris (FR)
(72) Inventeur: MERCIER, Sylvain, 38054 GRENOBLE CEDEX 09 (FR); DE PAOLI, Lionel, 38054 GRENOBLE CEDEX 09 (FR); BAZIN, Pascal, 38054 GRENOBLE CEDEX 09 (FR); PHLIPPOTEAU, Vincent, 38054 GRENOBLE CEDEX 09 (FR)
(74) Mandataire: Brevalex

(57) **Abrégé**

La présente invention concerne un dispositif de stockage ou de conversion d'énergie. Le dispositif comprend un carter fermé, le carter comprenant une paroi entourant un intérieur du carter et comprenant une première partie de paroi et une deuxième partie de paroi, la première partie ayant une conductivité thermique (λ) supérieur ou égal à 100 W/(m.K), de préférence supérieur ou égal à 200 W/(m.K). Le dispositif comprend également un dispositif électronique en contact thermique avec un côté extérieur (80) de la première partie de paroi. Ledit dispositif de stockage ou de conversion d'énergie est disposé à l'intérieur du carter et immergé dans un fluide de refroidissement.

## Description

### Domaine technique et état de la technique antérieure

Différentes solutions existent pour refroidir des composants électroniques. La solution la plus simple est le refroidissement naturel, c'est-à-dire sans circulation forcée, avec de l'air ou un fluide. Cette solution est d'une performance réduite. La circulation forcée de l'air ou d'un fluide permet d'améliorer l'efficacité du refroidissement et donc la densité de puissance de l'électronique. Des solutions plus performantes existent, à savoir le refroidissement par ébullition et par condensation, mais ces dernières sont complexes à mettre en oeuvre. Les solutions généralement disponibles sont principalement les technologies par plaque froide (refroidissement forcé) et par immersion avec (refroidissement par ébullition / condensation) ou sans changement phase (refroidissement forcé). La technologie par plaque froide comprend généralement un fluide qui circule dans un tube intégré au sein d'une plaque. Des composants électroniques sont positionnés sur la plaque et la chaleur est transférée du composant au fluide. Cette technologie, simple et peu onéreuse, est très répandue dans le domaine de l'électronique de puissance. Dans la technologie par immersion sans changement de phase, l'électronique à refroidir est immergée dans un fluide diélectrique, et positionnée à l'intérieur d'une enceinte généralement ouverte. Grâce à une pompe, le fluide diélectrique circule à l'intérieur de cette enceinte et assure le refroidissement de l'électronique. Un échangeur permet de refroidir le fluide avant que ce dernier soit réinjecté au sein de l'enceinte. Dans la technologie par immersion avec changement de phase l'électronique est positionnée à l'intérieur d'une enceinte étanche. L'électronique est également immergée dans un fluide diélectrique. Une zone libre, sans fluide, est présente au-dessus de l'électronique. Après échauffement, le fluide passe à l'état de vapeur. Cette dernière est condensée au contact de la surface froide du tube du condenseur. Le condenseur peut être positionné à l'intérieur ou à l'extérieure de l'enceinte.

La présente invention se rapporte au refroidissement couplé par immersion et plaque froide de composants de stockage ou de conversion d'énergie, par exemple électrochimiques et/ou magnétiques d'une part et de composants électroniques d'autre part.

Les documents KR102031645B1, KR20210130542, US20170179551 décrivent des carters configurés pour être refroidis par un liquide de refroidissement. Le document FR3086103 décrit une batterie disposée dans un carter, avec un circuit électronique plaqué contre le carter. Le document FR3109025 décrit une batterie logée dans un carter rempli d'un liquide diélectrique destiné au refroidissement de la batterie.

Un composant de stockage ou conversion d'énergie est immergé au sein d'une enceinte ou carter étanche. Ce composant est refroidi par circulation externe de fluide. Un ou plusieurs composants électroniques sont refroidis par effet plaque froide sur au moins une face de l'enceinte au contact avec le fluide de refroidissement.

### EXPOSÉ DE L'INVENTION

C'est par conséquent un but de la présente invention d'offrir un dispositif de stockage ou de conversion d'énergie comprenant :
- un carter fermé, le carter comprenant une paroi entourant un intérieur du carter et comprenant une première partie de paroi et une deuxième partie de paroi, la première partie ayant une conductivité thermique (λ) supérieur ou égal à 100 W/(m.K), de préférence supérieur ou égal à 200 W/(m.K),
- un dispositif électronique en contact thermique avec un côté extérieur de la première partie de paroi,
- le dispositif de stockage ou de conversion d'énergie étant disposé à l'intérieur du carter et immergé dans un fluide de refroidissement.

Avantageusement la première partie dispose d'une résistance thermique inférieure à la deuxième partie ou la première partie dispose d'une résistance thermique égale à la deuxième partie.

Il est possible que la résistance thermique de la première partie de paroi est inférieure d'un facteur 2 ou plus par rapport à la résistance thermique de la deuxième partie. De façon alternative ou supplémentaire la surface de la première partie de paroi peut être inférieure à la surface de la deuxième partie, de préférence la surface de la première partie présentant 10% ou moins, de préférence 3% ou moins, de la surface de la deuxième partie.

La première partie de paroi peut comprendre un matériau avec une conductivité thermique supérieure par rapport à un matériau compris par la deuxième partie de paroi, de préférence supérieur d'un facteur 2 ou plus.

Le dispositif électronique peut être posé en contact direct avec le côté extérieur de la première partie de paroi, de préférence une partie du dispositif électronique peut traverser la première partie de paroi jusqu'à l'intérieur du carter.

Le dispositif électronique ou un support du dispositif électronique peut faire partie de la première partie de paroi, de préférence la première partie de paroi comprenant un circuit imprimé.

Une partie du dispositif électronique peut traverser la première partie de paroi jusqu'à l'intérieur du carter, de préférence la partie traversant étant des pièces métalliques traversant assurant un contact électrique entre composantes électroniques situées à l'intérieur et situées à l'extérieur du carter ou de l'enceinte.

Un fonctionnement du dispositif électronique et un fonctionnement du dispositif de stockage ou de conversion d'énergie peuvent être liés de façon à ce que un besoin de refroidissement a lieu au même moment dans lesdits dispositifs.

Le dispositif peut comprendre une entrée de fluide et une sortie de fluide permettant un échange du fluide de refroidissement entre l'intérieur et l'extérieur du carter.

Après l'entrée, le fluide peut être contraint de passer au contact de la première partie de paroi avant de pouvoir s'écouler vers le dispositif de stockage ou de conversion d'énergie. L'entrée de fluide peut être configurée pour diviser un fluide entrant en un premier flux entrant et un deuxième flux entrant, de préférence le premier flux entrant représentant 30% ou plus du fluide entrant.

L'entrée de fluide peut être configurée pour diriger le premier flux entrant vers la première partie de paroi.

L'entrée de fluide peut aussi comprendre une plaque perforée formant un canal ensemble avec la première partie de paroi.

Après l'entrée, une deuxième plaque perforée, configurée pour assurer une distribution homogène du fluide de refroidissement sur le dispositif de stockage ou de conversion d'énergie, peut être prévue.

Le fluide de refroidissement peut couvrir entièrement la première partie de paroi.

La première partie de paroi peut comprendre plusieurs plaques indépendantes disposées à différents endroits de la paroi du carter.

Avantageusement, un échangeur peut être disposé à l'extérieur du carter, l'échangeur étant configuré pour échanger le fluide de refroidissement entre l'intérieur et l'extérieur du carter et pour changer une température du fluide de refroidissement. Le dispositif de stockage ou de conversion d'énergie peut être constitué de composants électrochimiques et/ou magnétiques

Le dispositif de stockage d'énergie peut être une batterie constituée de cellules électrochimiques ou d'inductances et dans lequel le dispositif électronique est configuré pour gérer un fonctionnement de la batterie.

Une température du fluide de refroidissement peut être choisie pour refroidir ou pour chauffer le dispositif électronique et/ou le dispositif de stockage ou de conversion d'énergie.

Le fluide de refroidissement peut posséder d'une température entre -40°C et 85°C.

### BRÈVE DESCRIPTION DES DESSINS

La présente invention sera mieux comprise sur la base de la description qui va suivre et des dessins en annexe sur lesquels:
[Fig. 1] montre un dispositif de stockage ou de conversion d'énergie,
[Fig. 2] montre une vue de détail de la première partie de paroi avec le dispositif électronique,
[Fig. 3] montre une entrée de fluide comprenant une plaque perforée qui forme un canal avec une première partie de paroi.

### Exposé détaillé de modes de réalisation particuliers

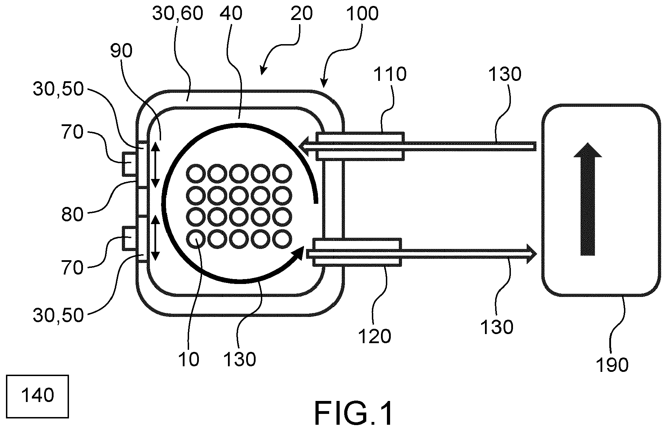

La figure 1 montre un dispositif (10) de stockage ou de conversion d'énergie. Ledit dispositif peut être un dispositif électrochimique de stockage. De manière générale le dispositif de stockage ou de conversion peut être un composant électrochimique, par exemple une cellule électrochimique de batterie ou une cellule de pile à combustible ou une cellule d'un électrolyseurs ou un composant de stockage ou de conversion magnétique, par exemple un dispositif de stockage d'énergie par inductance, ou un transformateur électrique.

La figure 1 montre aussi un carter fermé (20) possédant une paroi (30). Par « fermé » nous comprenons qu'un fluide de refroidissement (130) qui se trouve à l'intérieur (40) du carter ne peut pas s'échapper de façon incontrôlée. Ledit fluide de refroidissement peut uniquement sortir du carter par une sortie (120) de fluide prévue dans la paroi du carter. Le fluide de refroidissement peut entrer à l'intérieur du carter par une entrée de fluide (110), également prévue dans la paroi. Ainsi, la paroi entoure l'intérieur du carter ensemble avec le fluide de refroidissement. Ledit dispositif de stockage ou de conversion d'énergie est disposé à l'intérieur du carter et immergé dans le fluide de refroidissement.

L'entrée et la sortie de fluide sont prévues de façon optionnelle afin de faciliter le changement du fluide de refroidissement. Changer le fluide permet par exemple de garder le fluide à une température choisie. Le fluide de refroidissement peut posséder une température entre -40°C et 85°C à l'intérieur du carter. Un échangeur de fluide (190) peut être prévu à l'extérieur du carter et peut être connecté à l'entrée et à la sortie de fluide. L'échangeur est configuré pour faire circuler le fluide à l'intérieur du carter et pour échanger le liquide de refroidissement entre l'intérieur et l'extérieur du carter. La température du fluide sorti du carter peut être changée par l'échangeur, par exemple la température peut être baissée. De façon générale, le fluide de refroidissement peut être gazeux ou liquide. Il peut s'agir par exemple d'un fluide diélectrique. Le fluide de refroidissement peut également se trouver sous pression dans le carter. De manière générale le fluide de refroidissement est un fluide caloporteur. Ledit fluide de refroidissement peut être employé pour effectuer un échange d'énergie thermique entre un intérieur et un extérieur du carter. Ainsi, de l'énergie peut être extrait de l'intérieur du carter pour refroidir. Il est également possible d'apporter de l'énergie thermique à l'intérieur du carter pour chauffer ou augmenter une température.

Après l'entrée (110), le fluide peut être contraint de passer au contact de la première partie de paroi avant de pouvoir s'écouler vers le dispositif de stockage ou de conversion d'énergie. Autrement dit, le dispositif peut comprendre un guidage du fluide de refroidissement configuré pour faire passer le fluide au contact de la première partie de paroi directement après l'entrée du fluide.

De façon générale, une propriété isolante d'une paroi peut être décrite par sa résistance thermique. Ladite résistance thermique quantifie l'opposition de la paroi à un flux thermique traversant la paroi. Elle dépend, entre autres, de la conductivité thermique des différents matériaux compris par la paroi et de leur arrangement pour former la paroi.

La paroi du carter comprend une première partie de paroi (50) et une deuxième partie de paroi (60). La résistance thermique de la première partie de paroi peut être inférieure par rapport à la résistance thermique de la deuxième partie de paroi. La résistance thermique de la première partie de paroi peut aussi être égale à la deuxième partie de paroi. Il est possible d'utiliser le même matériau pour les deux parties de paroi. Ainsi, la première partie de paroi peut disposer d'une résistance thermique inférieure à la deuxième partie ou la première partie de paroi peut disposer d'une résistance thermique égale à la deuxième partie.

La deuxième partie de paroi peut être prévue pour assurer une isolation thermique de l'intérieur du carter par rapport à un extérieur (140). Ainsi, un flux thermique à travers de la deuxième partie de paroi peut être techniquement négligeable. De façon alternative, la deuxième partie de paroi n'est pas prévue pour assurer d'isolation thermique. La résistance thermique de la première partie de paroi peut être moins importante que celle de la deuxième partie. La résistance thermique de la première partie peut être prévue pour permettre un flux thermique suffisant pour refroidir un côté extérieur de la première partie de paroi (80). La résistance thermique de la première partie de paroi peut aussi être égale à celle de la deuxième partie de paroi. La résistance thermique peut être prévue de façon à ce qu'une température de l'extérieur de la première partie est principalement identique à l'intérieur du carter. La première partie de paroi permet ainsi de refroidir des composants qui se trouvent en contact thermique avec son côté extérieur (80). Un dispositif électronique (70), posé sur le côté extérieur de la première partie de paroi, est ainsi refroidi par le fluide de refroidissement tout comme le dispositif de stockage ou de conversion d'énergie est refroidi à l'intérieur du carter. Un rapport entre la résistance thermique de la deuxième et la première partie de paroi peut être choisi à 1 ou à supérieur à 1, par exemple 2 ou plus de 2. Autrement dit, la résistance thermique de la première partie peut être inférieure rapport à la résistance thermique de la deuxième partie.

De manière générale, une conductivité thermique (λ) de la première partie de paroi est supérieur ou égal à 100 W/(m.K), de préférence supérieur ou égal à 200 W/(m.K). La conductivité thermique peut aussi être comprise entre 120 et 380 W/m.K, correspondant au Laiton et Cuivre. Ainsi, la première partie de paroi et/ou la deuxième partie de paroi peut comprendre ou consister en Laiton ou Cuivre.

De préférence, le fluide de refroidissement couvre entièrement la première partie de paroi afin d'assurer un bon échange thermique entre l'extérieur de la première partie et le fluide de refroidissement.

Afin de fournir aux différentes parties de paroi lesdites résistances thermiques, les parties de paroi peuvent comprendre des matériaux ayant des conductivités thermiques différentes. Par exemple, des sandwich de matériau comprenant des feuilles isolantes internes peuvent être utilisés. Il peut s'agir d'un sandwich aluminium ou carbone avec un revêtement en PTFE ou PE. La première partie de paroi peut comprendre un matériau ayant une conductivité thermique supérieure par rapport à un matériau compris par la deuxième partie de paroi. De préférence, ladite conductivité thermique peut être supérieure d'un facteur 2 ou plus.

Avantageusement, une surface de la première partie de paroi (90) est inférieure à une surface de la deuxième partie de paroi (100). De préférence la surface de la première partie présente 10% ou moins de la surface de la deuxième partie. De préférence, la surface de la première partie peut présenter entre 3% et 10% de la surface de la deuxième partie Une surface relativement petite de la première partie limite le flux d'énergie total entre l'intérieur et l'extérieur du carter. Ainsi, la température à l'intérieur du carter peut rester relativement stable malgré une entrée d'énergie à travers de la première partie de paroi, qui est pourtant nécessaire pour refroidir le dispositif électronique. Aussi, si la deuxième partie de paroi est plus isolante, cela permet de limiter une influence de l'environnement extérieur sur la température du fluide de refroidissement.

La première partie de paroi peut aussi être prévue en plusieurs parties. Par exemple, la figure 1 montre deux plaques indépendantes disposées à deux endroits différents de la paroi du carter, formant ensemble la première partie de paroi. Dans ce cas, l'ensemble de la surface des plaques reste inférieur à la surface de la deuxième partie de paroi. L'intérêt de l'invention est ainsi de permettre une gestion thermique fine sur des composants de stockage et de conversion de l'énergie, dont les performances en rendement mais aussi en vieillissement sont fortement affectées par la température alors qu'ils sont eux-mêmes générateur de chaleur, tout en assurant par le même système un refroidissement de composants électroniques moins sensibles à la température mais rendus plus accessibles par un maintien à l'extérieur de l'enceinte facilitant leur connectivité et leur maintenance.

De façon similaire, l'intérêt de l'invention est également de permettre un refroidissement optimal pour des composants magnétiques dont la forte densité massique et la fable surface périphérique rendent difficile un refroidissement efficace, tout en assurant par le même système un refroidissement de composants électroniques moins sensibles à la température mais rendus plus accessibles par un maintien à l'extérieur de l'enceinte facilitant leur connectivité et leur maintenance.

Les composants immergés peuvent être à ce titre typiquement des cellules électrochimiques de stockage d'énergie, ou des cellules électrochimiques de pile à combustible ou d'électrolyseurs, ainsi que des stockage d'électricité par induction, ou des convertisseurs électriques à base magnétique (autrement dit: des transformateurs bobinés).

Les composants moins sensibles et pouvant être positionnés à l'extérieur de l'enceinte en plaque froide peuvent être typiquement des composants électroniques classiques tels que des composants passifs, des circuits intégrés, des condensateurs, des diodes, des transistors, des inductances de faibles dimensions ou masse, avec des besoins de refroidissement moindres. Les composants ayant des besoins de maintenance ou intervention élevés seront également placés de façon privilégiés en zone extérieure et refroidis par plaque froide.

Avantageusement, les composants électroniques extérieurs sont liés électriquement au fonctionnement des composants immergés, permettant un refroidissement simultané des deux catégories de composants lors de leur fonctionnement. Autrement dit, un fonctionnement du dispositif électronique et un fonctionnement du dispositif de stockage ou de conversion d'énergie sont liés de façon à ce qu'un besoin de refroidissement a lieu au même moment dans lesdits dispositifs.

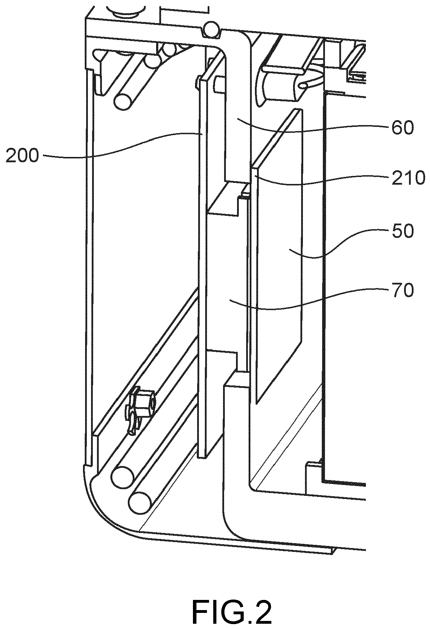

La figure 2 montre une vue de détail de la première partie de paroi avec le dispositif électronique. Dans l'exemple montré, la première partie de paroi est une plaque posée de l'intérieur du carter devant une ouverture dans la paroi du carter. Il s'agit d'une paroi de section plus faible par rapport à la deuxième partie de paroi. La plaque peut comprendre de l'aluminium. De la colle (210) peut être disposée à un bord de la plaque pour la fixer sur la deuxième partie de paroi et pour assurer une étanchéité. Le dispositif électronique est posé en contact avec la plaque.

De façon générale, le dispositif électronique est posé en contact direct avec le côté extérieur de la première partie de paroi. Il est également possible qu'une partie du dispositif électronique traverse la première partie de paroi jusqu'à l'intérieur du carter et se trouve en contact avec le fluide de refroidissement. Le dispositif électronique peut ainsi devenir partie intégrante de la première partie de paroi.

Dans l'exemple montré, le dispositif électronique (70) est posé à plat contre la plaque en aluminium et ainsi en contact direct avec la plaque. Le dispositif électronique peut être posé via un drain thermique, type silpad afin d'assurer un contact thermique correct et ainsi limiter la résistance thermique induite aux niveau des interfaces. Il est tenu par une plaque de fixation (200).

La première partie de paroi pourrait également être une plaque de circuit imprimé. Dans l'exemple montré dans la figure 2, au lieu d'une plaque en aluminium, il pourrait s'agir d'une plaque de circuit imprimé avec un ou plusieurs dispositifs électroniques posés sur la plaque.

Avantageusement, une partie du dispositif électronique traverse la première partie de paroi jusqu'à l'intérieur du carter. Dans ce cas, des pièces métalliques traversant assurent un contact électrique entre les composantes situées à l'intérieur et ceux situées à l'extérieur du carter ou de l'enceinte. Autrement dit il existe un contact de puissance traversant.

Dans l'exemple montré dans la figure 2, un dispositif électronique, par exemple une puce ou circuit intégré électronique, peut traverser la plaque du circuit imprimé avec ses pattes ou broches de contact pour arriver jusqu'à l'intérieur du carter. Dans ce cas, les pattes de contact pourraient être soudées du côté intérieur sur la plaque du circuit imprimé et ainsi rentrer en contact avec le fluide de refroidissement. Ledit contact avec le fluide améliore le refroidissement du dispositif électronique. Il est également possible de prévoir un circuit imprimé qui fait office de première partie de paroi et des composants électroniques qui peuvent être positionnés côté intérieur du carter, donc dans le fluide de refroidissement.

Ainsi, le dispositif électronique (70) ou un support du dispositif électronique peuvent faire partie de la première partie de paroi, de préférence la première partie de paroi comprenant un circuit imprimé. Une partie du dispositif électronique (70) peut aussi traverser la première partie de paroi jusqu'à l'intérieur du carter. Avantageusement, ladite partie traversant comprend des pièces métalliques traversant assurant un contact électrique entre composantes électroniques situées à l'intérieur et situées à l'extérieur du carter ou de l'enceinte.

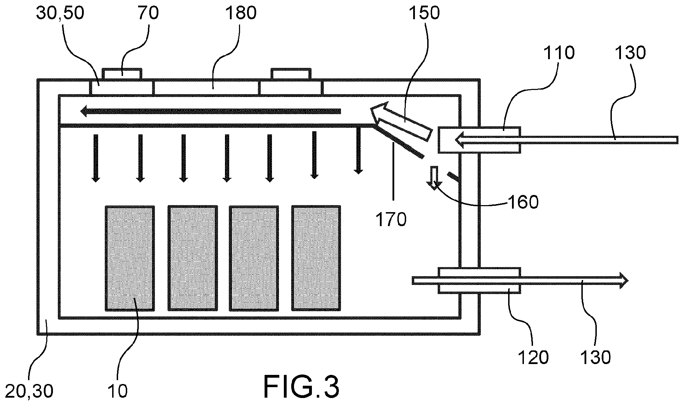

Selon une variante, le flux de fluide entrant dans le carter peut être divisé en un premier flux entrant (150) et un deuxième flux entrant (160). La figure 3 montre l'entrée de fluide (110) configurée pour diviser le fluide entrant en un premier flux entrant (150) et en un deuxième flux entrant (160). Le premier flux entrant peut représenter par exemple 30% ou plus de l'ensemble du fluide entrant par l'entrée. L'entrée de fluide peut être configurée pour diriger le premier flux entrant vers la première partie de paroi. Diriger le premier flux entrant vers la première partie de paroi permet d'avoir un transfert thermique particulièrement efficace entre le dispositif électronique (70) et le fluide de refroidissement. Par ajustement du pourcentage que le premier flux représente par rapport à la totalité du fluide entrant le refroidissement du dispositif électronique (70) peut être ajusté.

Dans l'exemple montré dans la figure 3, l'entrée de fluide (110) comprend une plaque perforée (170) qui forme un canal (180) avec la première partie de paroi (50). Le premier flux entrant (150) traverse majoritairement ce canal (180) pour passer près de la première partie de paroi. Le fluide traverse également les trous de la plaque qui se trouvent du côté opposé de la première partie de paroi pour arriver près du dispositif de stockage ou de conversion d'énergie (10). La plaque comprend également des perforations situées directement à côté de l'entrée de fluide, permettant ainsi au fluide entrant de former un deuxième flux (160) de fluide entrant qui arrive directement près du dispositif de stockage ou de conversion d'énergie (10), sans passer à côté de la première partie de paroi (50).

Il est également possible de prévoir, après l'entrée (110), une deuxième plaque perforée. La deuxième plaque est configurée pour assurer une distribution homogène du fluide de refroidissement sur le dispositif de stockage ou de conversion d'énergie. La deuxième plaque perforée peut être positionnée en dessous de la plaque perforée (170). La deuxième plaque perforée peut être perforée en entrée et en sortie du fluide de refroidissement et ainsi assurer une répartition du fluide de refroidissement autour du dispositif de stockage ou de conversion d'énergie. Ainsi, après l'entrée (110), une deuxième plaque perforée peut être prévue, la deuxième plaque étant configurée pour assurer une distribution homogène du fluide de refroidissement sur le dispositif de stockage ou de conversion d'énergie.

Le flux de fluide entrant est ainsi divisé en une première partie (150) et en une deuxième partie (160) en dépendance de la taille et du placement des trous de perforation présentes dans la plaque (170).

Avantageusement, le dispositif de stockage d'énergie peut être une batterie constituée de cellules électrochimiques ou d'inductances magnétiques et le dispositif électronique peut être configuré pour gérer le fonctionnement de la batterie, par exemple un cycle de charge ou de décharge. Un refroidissement de la batterie et de l'électronique de gestion de la batterie peut ainsi être avantageusement combiné.

Avantageusement, le carter est configuré pour assurer la gestion de la batterie dans le cas d'un emballement thermique. Le carter dispose ainsi d'une stabilité suffisante pour contenir la batterie dans le cas d'un déchargement incontrôlé de l'énergie stockée dans la batterie, en assurant si nécessaire une évacuation du flux de dégazage vers l'extérieur du carter.

Par son système de refroidissement efficace, le refroidissement des composants de stockage par immersion facilite la mitigation des échauffements et limite le risque d'emballement thermique - et sa propagation - en cas de défaut au niveau d'une cellule de la batterie.

Le carter peut également être pourvu pour protéger la batterie contre des chocs mécaniques et ainsi prévenir un endommagement mécanique de la batterie.

Le carter décrit ci-dessus avec le fluide de refroidissement et l'éventuel l'échangeur peuvent également être utilisés pour réchauffer le dispositif électrochimique et/ou magnétique de stockage ou de conversion d'énergie (10) ainsi que le dispositif électronique. Dans ce cas, l'échangeur ou tout autre système de préchauffage ajoute de l'énergie au fluide de refroidissement afin d'élever sa température. Ceci représente un avantage particulier pour les dispositifs électrochimiques dont les performances sont sensibles à la température. La température du fluide de refroidissement peut ainsi être choisie pour refroidir ou pour chauffer le dispositif électronique et/ou le dispositif de stockage ou de conversion d'énergie.

## Revendications

1. Dispositif (10) de stockage ou de conversion d'énergie, disposé à l'intérieur (40) d'un carter (20) fermé, le carter comprenant une paroi (30) entourant un intérieur (40) du carter et , la paroi comprenant une première partie (50) de paroi et une deuxième partie (60) de paroi, la première partie de paroi ayant une conductivité thermique (λ) supérieure ou égale à 100 W/(m.K), de préférence supérieure ou égale à 200 W/(m.K) ;
le carter comprenant un dispositif électronique (70) en contact thermique avec un côté extérieur (80) de la première partie de paroi ;
le dispositif de stockage ou de conversion d'énergie étant disposé à l'intérieur (40) du carter et immergé dans un fluide de refroidissement (130) ;
le carter étant tel que :
- la conductivité thermique de la première partie de paroi est au moins deux fois supérieure à la conductivité thermique de la deuxième partie de paroi ;
- la surface de la première partie de paroi est inférieure à la surface de la deuxième partie de paroi.

2. Dispositif selon la revendication 1, dans lequel la surface de la première partie de paroi présente 10% ou moins, et de préférence 3% ou moins, de la surface de la deuxième partie de paroi.

3. Dispositif selon l'une quelconque des revendications précédentes dans lequel le dispositif électronique est posé en contact direct avec un côté extérieur de la première partie de paroi, de préférence
une partie du dispositif électronique traverse la première partie de paroi jusqu'à l'intérieur du carter.

4. Dispositif selon l'une quelconque des revendications précédentes dans lequel le dispositif électronique (70) ou un support du dispositif électronique fait partie de la première partie de paroi, de préférence la première partie de paroi comprenant un circuit imprimé.

5. Dispositif selon la revendication 4 dans lequel une partie du dispositif électronique (70) traverse la première partie de paroi jusqu'à l'intérieur du carter, de préférence la partie traversant étant des pièces métalliques traversant assurant un contact électrique entre composantes électroniques situées à l'intérieur et situées à l'extérieur du carter.

6. Dispositif selon l'une quelconque des revendications précédentes comprenant une entrée (110) de fluide et une sortie (120) de fluide permettant un échange du fluide de refroidissement entre l'intérieur et l'extérieur du carter (140).

7. Dispositif selon la revendication 6 dans lequel, après l'entrée (110), le fluide est contraint de passer au contact de la première partie de paroi avant de pouvoir s'écouler vers le dispositif de stockage ou de conversion d'énergie.

8. Dispositif selon la revendication 7 dans lequel l'entrée de fluide est configurée pour diviser un fluide entrant en un premier flux entrant (150) et un deuxième flux entrant (160), de préférence le premier flux entrant représentant 30% ou plus du fluide entrant.

9. Dispositif selon la revendication 8 dans lequel l'entrée de fluide est configurée pour diriger le premier flux entrant vers la première partie de paroi.

10. Dispositif selon l'une quelconque des revendication 6 à 9 dans lequel, l'entrée de fluide comprend une plaque perforée (170) formant un canal (180) ensemble avec la première partie de paroi.

11. Dispositif selon l'une quelconque des revendications 5 à 10 comprenant, après l'entrée (110), une deuxième plaque perforée, configurée pour assurer une distribution homogène du fluide de refroidissement sur le dispositif de stockage ou de conversion d'énergie.

12. Dispositif selon l'une quelconque des revendications précédentes dans lequel le fluide de refroidissement couvre entièrement la première partie de paroi.

13. Dispositif selon l'une quelconque des revendications précédentes dans lequel la première partie de paroi comprend plusieurs plaques indépendantes disposées à différents endroits de la paroi du carter.

14. Dispositif selon l'une quelconque des revendications précédentes et la revendication 6 comprenant un échangeur (190) disposé à l'extérieur du carter,
l'échangeur étant configuré pour échanger le fluide de refroidissement entre l'intérieur et l'extérieur du carter et pour changer une température du fluide de refroidissement.

15. Dispositif selon l'une quelconque des revendications précédentes dans lequel le dispositif de stockage d'énergie est une batterie constituée de cellules électrochimiques ou d'inductances et dans lequel le dispositif électronique est configuré pour gérer un fonctionnement de la batterie.
